Europäisches Patentamt

European Patent Office

Office européen des brevets

(19)

(11) EP 0 932 253 A2

(12) **EUROPEAN PATENT APPLICATION**

(43) Date of publication:
**28.07.1999 Bulletin 1999/30**

(51) Int Cl.⁶: **H03G 3/00**

(21) Application number: **99300238.5**

(22) Date of filing: **14.01.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **15.01.1998 US 71564 P**

(71) Applicant: **Texas Instruments Incorporated Dallas, Texas 75251 (US)**

(72) Inventors:
• **Gandhi, Prashant P.**
  **Sunnyvale, CA 94086 (US)**

• **Smith, Sterling**
  **Plano, Texas 75024 (US)**
• **Hochschild, James R.**
  **Plano, Texas 75075 (US)**
• **Yang, Steve**
  **Plano, Texas 75024 (US)**

(74) Representative: **Holt, Michael**
   **Texas Instruments Limited,**
   **P.O. Box 5069**
   **Northampton NN4 7ZE (GB)**

(54) **Soft gain update method & apparatus**

(57) This invention is concerned with updating (or changing) volume (or gain) in a soft manner for voice/speech and 10% audio applications. It is found that, from mute to full-scale gain update, filtered gain update procedure (in line or domain) provides subjectively superior performance over instantaneous or zero-cross gain update or step-based update in the decibel domain. Specifically, it is found that about 90 milliseconds (ms) of update time for first-order (linear) update and about 45 milliseconds of update time for second-order (quadratic) update provide the least audible distortion, with the quadratic update performing significantly better than the linear first-order update. Both filtered updates are carried out in the linear domain, not in the decibel domain.

FIG. 2

## Description

Field of the Invention

The present invention relates to updating of gain in audio amplification, particularly to updating of gain in complex integrated circuits known as digital signal processors (or "DSP").

Background of the Invention

Traditionally, gain or volume in an audio context is updated instantaneously when an update command is received by a gain processor. However, when the gain is changed from its present value of $G_{old}$ to a new value, $G_{new}$, the audio signal exhibits an abrupt jump (or "discontinuity") at the transition instance. A gain update can also be delayed until the signal to which the volume change will be applied is crossing the zero value. This is "zero-cross" gain update. Zero-cross gains usually operate in a time-out mode which forces a gain update if a zero-cross of the signal does not occur within a prescribed time, about 100 ms. For a constant or dc signal, both instantaneous and zero-cross updates yield identical results.

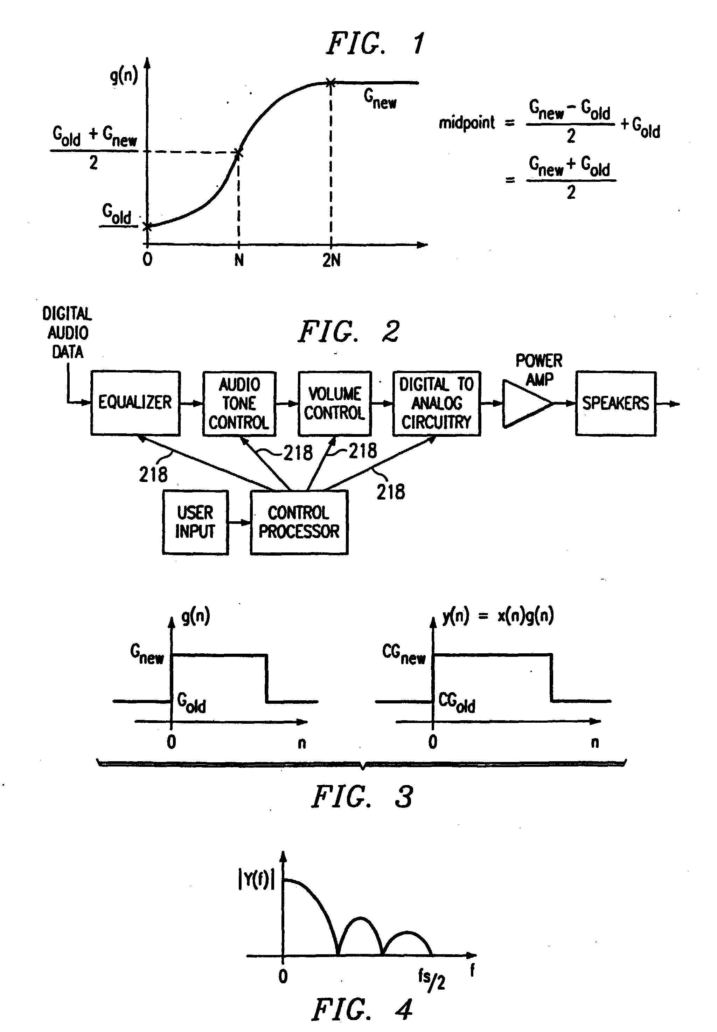

Figure 3 depicts this time-domain phenomenon due to a gain signal, g(n), being multiplied by a constant data signal, x(n) = c. The gain applied signal, y(n) = x(n)g(n), results. Discontinuity at time 0 is clearly exhibited.

With a dc signal, an instantaneous gain-update causes a sharp transient whose energy is distributed over the entire audible band ($0 \leq f \leq fs/2$), causing unpleasant audible effects. Figure 4 depicts this phenomenon in the frequency-domain due to a gain signal, G(f), where $0 \leq f \leq fs/2$, being multiplied by a constant data signal, $x(f) = c\delta(f)$, the discrete-time fourier transform of x(n). The gain applied signal:

$$Y(f) = \frac{G(f)^{*}x(f)}{2\pi} = \frac{G(f)^{*}c\delta(f)}{2\pi} = \frac{cG(f)}{2\pi}$$

results.

However, most signals are non-constant in that they are time-varying. Prior hardware-based solutions have employed zero-cross gain update methodology, which provides slightly better audible performance than the instantaneous gain update method for non-constant signals. The application of new gain to non-constant signals during zero crossing of x(n) helps reduce the audible artifacts to a small degree.

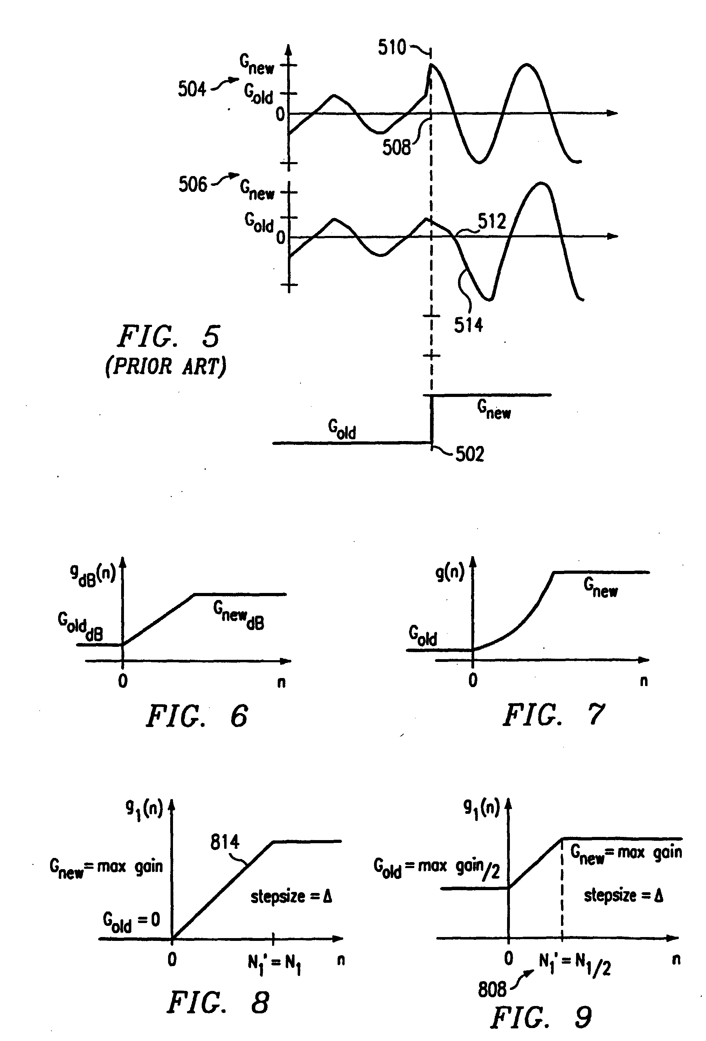

Figure 5 depicts the results of instantaneous and zero-cross gain updating. A gain update command 502 is received simultaneously for both instantaneous 504 and zero-cross gain update 506. For an instantaneous gain update, the gain is updated at time 508 when the command is received. This immediate update results in a signal spike 510 causing audible audio artifacts. For a zero-cross update, the gain is updated after the command is received, once the signal is near the zero value 512. However, the signal is still updated instantaneously at the zero-cross, again resulting in audible audio artifacts at time 514.

A "soft mute" is another current gain update implementation. In soft mute gain update, the gain level is gradually reduced to zero (-∞ in the decibel domain) over a time frame that is easily perceptible by the listener (e.g. several seconds). This implementation serves to reduce the audible artifacts created by instantaneous or zero-cross updates. However, the gain update time is detectable by the listener.

Summary of the Invention

The present application describes an automatic soft gain update architecture in which the gain is automatically swept from value $G_{old}$ to value $G_{new}$ in the linear domain over a period of time which is imperceptible to the listener. Such a gain sweep reduces the unpleasant audible effects caused by discontinuity during instantaneous or zero-cross updates which take place in the decibel domain and eliminates the perception of the length of the update by the user. Two specific soft gain update implementations, namely first-order (or "linear") update and second-order (or "quadratic") update will be described.

The first-order gain function is continuous. However, its derivative is discontinuous at 0 and $N_1$. Linear gain update can be implemented in either a constant-step or constant-time approach. In the constant-step approach, the gain is automatically swept linearly over a number of steps determined by $G_{old}$ and $G_{new}$. The number of steps determines the time taken for the gain sweep to complete. In the constant-time approach, the gain is automatically swept linearly from $G_{old}$ to $G_{new}$. Over a specified period of time, regardless of the number of steps between $G_{old}$ and $G_{new}$. Sweep time for linear gain updates is $T_1$, where $T_1 = N_1 Ts$, with $N_1$ indicating the number of steps required for the gain sweep and Ts being the sampling period.

The second-order gain function and its first derivative are both continuous. However, its second derivative is discontinuous. In the quadratic constant-time embodiment, the gain is automatically swept according to a ramping function. The duration of time of the gain sweep from $G_{old}$ to $G_{new}$ is of significant importance as well. Sweep time for a quadratic gain update is $T_2$, where $T_2 = N_2 Ts$, with $N_2$ indicating the number of steps required for the gain sweep and Ts being the sampling period.

One advantage of the present disclosure is that polynomial gain update procedures allow significant reduction in audible artifacts. Another advantage of the present disclosure is that the polynomial gain update can be performed in a linear (first-order), quadratic (second-order), or higher-ordered fashion. Another advantage is that from mute to full-scale gain update, a filtered gain update procedure in the linear domain, provides subjectively superior performance over instantaneous or zero-cross gain update or step-based update in the decibel domain. Another advantage is the guarantee of perfect gain update in that there are no gain errors or approximations. That is, the gain value $G_{new}$ is achieved exactly as opposed to an analog representation which may deviate from $G_{new}$ by 2% or more.

Brief Description of the Drawings

The present invention will now be further described, by way of example, with reference to the accompanying drawings, which show important exemplary embodiments of the present invention wherein:

Figure 1 represents the quadratic constant-time filter soft gain update;
Figure 2 depicts a block diagram of the signal processing of an audio system which utilizes the soft gain update;
Figure 3 depicts the time-domain phenomenon due to a gain signal being multiplied by a constant data signal;
Figure 4 depicts the frequency-domain phenomenon due to a gain signal being multiplied by a constant data signal;
Figure 5 depicts the results of instantaneous and zero-cross gain updating;
Figure 6 depicts linear soft gain update response in the decibel domain;
Figure 7 depicts linear soft gain update response in the linear domain;
Figure 8 depicts the response of a constant-step soft gain update;
Figure 9 depicts the response of a gain update from 1/2 full scale to full-scale;
Figure 10 depicts in flowchart form the algorithm for controlling a linear constant-step gain update process;
Figure 11 illustrates a gain processor which implements a constant-step linear sweep gain update;
Figure 12A depicts the constant nature of $N_1$ in a constant time gain update which sweeps from mute to maxgain;
Figure 12B depicts the constant nature of $N_1$ in a constant time gain update which sweeps from maxgain/2 to maxgain;
Figure 13 represents the linear constant-time filter output desired;
Figure 14 schematically depicts the implementation of a linear constant-time difference equation;
Figure 15 illustrates a gain processor which implements a quadratic constant-time sweep gain update; and
Figure 16 depicts a microcode cycle-based DSP implementation of a table algorithm with a single adder.

Detailed Description of the Preferred Embodiments

The numerous innovative teachings of the present application will be described with particular reference to the presently preferred embodiment. However, it should be understood that this class of embodiments provides only a few examples of the many advantageous uses of the innovative teachings herein. In general, statements made in the specification of the present application do not necessarily delimit any of the various claimed inventions. Moreover, some statements may apply to some inventive features but not to others.

The present application provides a system of gain update in which the gain is automatically swept from $G_{old}$ to $G_{new}$ over a period of time in order to produce a gain update with is audibly smooth. In various embodiments, the period of time over which the gain is swept is derived in two ways. The first method described below is the constant step method. In the constant step method, the range of gain between mute and full scale is divided into steps. The time required to update gain is the same for each step. Therefore, gain updates with large differences between $G_{old}$ and $G_{new}$ take longer to complete than those with smaller differences. The response of a linear constant-step soft gain update is depicted in Figure 8. Linear constant-step soft gain update achieves a reduction in audible artifacts at gain update.

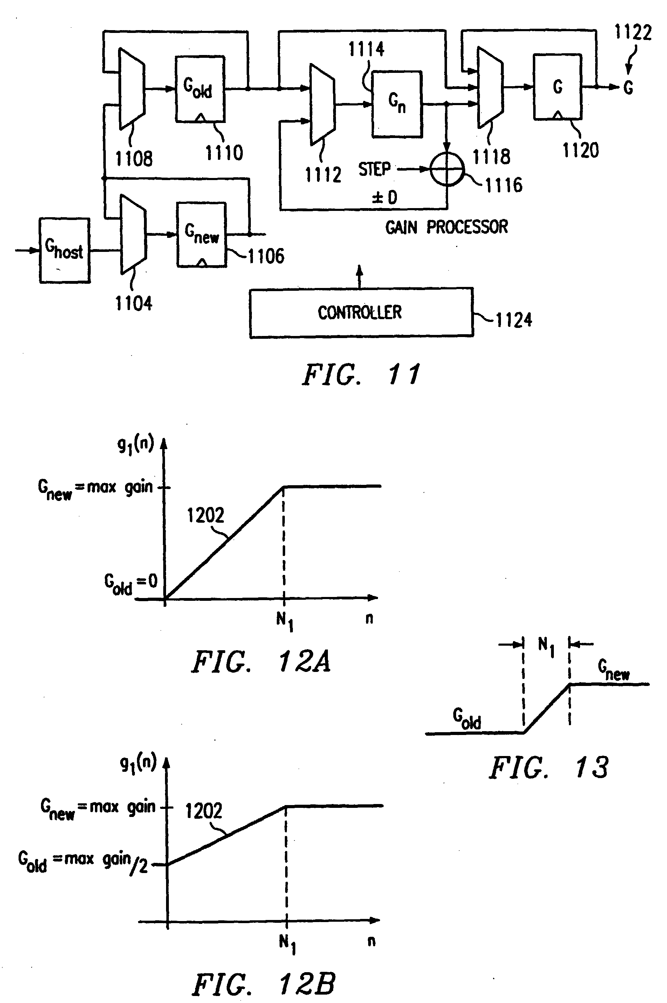

The second method described below is the constant-time method. In the constant time method, the time required to update gain from $G_{old}$ and $G_{new}$ is constant for each update regardless of the difference between $G_{old}$ and $G_{new}$. The response of a linear constant-time soft gain update is depicted in Figures 12A and 12B. Like linear constant-step updating, a linear constant-time soft gain update achieves a reduction in audible artifacts. However, the quadratic constant-time soft gain update, as depicted in Figure 1, results in a significant further reduction of audible artifacts due to its first-order continuity at $G_{new}$.

When sweeping from mute to largest gain, sweep times of about 90ms for linear gain updates and about 45ms for quadratic gain updates are found to have the most pleasant listening experience. In a 16-bit audio application, for instance, the greatest gain update sweep is from mute, $y(n) = 0$, to full-scale, $|y(n)| = 2^{15} - 1 = 32667$. Values of $N_i$ and $T_i$, $i = 1$ or 2, for sampling rates of 44.1 kHz and 48 kHz, respectively, are shown below:

| Fs | $N_1$ | $T_1$ | $N_2$ | $T_2$ | Ts (sampling period) |
|---|---|---|---|---|---|
| 44.1 kHz | 4096 | 92.88 ms | 2048 | 46.44 ms | 22.68 $\mu$s |
| 48.0 kHz | 4096 | 85.33 ms | 2048 | 42.67 ms | 20.83 $\mu$s |

Linear sweeping of the gain from one value to another has been implemented in software and in hardware. However, such sweep functions typically take place over a non-optimum period of time or in the decibel domain. Such sweep functions cause audible distortion. About 90 milliseconds (ms) of update time for first-order (linear) updates and about 45 milliseconds of update time for second-order (quadratic) updates provides the least audible distortion due to sweep time, with the quadratic update performing significantly better than the linear first-order update.

It is also important, in the presently preferred embodiment, that gain sweeping take place in the linear domain, not in the decibel domain, where $g_{dB}(n) = 20\log_{10}(g_{(n)})$, $g_{(n)} \geq 0$. If gain is swept in constant dB steps, e.g. from -90dB to 0dB in steps of 1 dB, a decibel response like that depicted in Figure 6 results.

The linear-domain response equivalent of Figure 6 is depicted in Figure 7. Applying a constant step-update to $g_{dB}(n)$ translates to exponential gain update in the linear-domain gain, resulting in significant audible artifacts, particularly when reaching $G_{new}$ 602. This response difference is meaningful due to the listener being subjectively sensitive to actual linear-domain gain values during gain updates while sensitive to dB gain during steady - states of gain. That linear gain values tend to be of significant importance when addressing gain update issues is well understood by one skilled in the art and has been documented in audio literature.

Audio muting is a special case of gain update in that the update takes place from some non-zero $G_{old}$ to a $G_{new}$ which is 0. Therefore, the same soft gain update may be used to implement a soft mute function.

Figure 8 depicts the response of a constant-step soft gain update. In constant-step gain update, the step-size, D, is the "discrete-time slope" of the line 814 joining the values of mute and full-scale or maxgain. Where mute = 0 and full-scale = $2^{15} - 1 = 32767$, in a 16-bit two's complement system, a D of 8 results in 4096 steps, the closest integer to:

$$\frac{32767}{N_1} = \frac{32767}{4096}$$

Therefore, when sweeping a gain update linearly from $G_{old}$ = mute to $G_{new}$ = full-scale, $N_1 = 4096$ gain steps are utilized, yielding an update time, $T_1$, of 85.33ms given a sample rate, fs, of 44.1 kHz. However, because the step-size is made constant, the actual number of steps for a particular gain update, $N_1'$, can differ from $N_1$. Figure 9 depicts the response of a gain update from 1/2 full scale to full-scale. If $G_{old}$ = full-scale/2 and $G_{new}$ = full-scale, only $N_1' = N_1/2$, or 2048, steps are needed.

Such a constant-step approach is not as smooth as the constant-time gain update, either linear or quadratic. For instance, assume a 16-bit system with full-scale or max gain of unity (0dB). Consider two gain updates: 1) $G_{old}$ = 0 = -• dB (mute) and $G_{new}$ = maxgain/2 = 1/2 = -6dB with $N_1' = N_{1/2}$ = 2048 steps; 2) $G_{old}$ = maxgain/2 = 1/2 = -6dB and $G_{new}$ = maxgain = 1 = 0dB with $N_1' = N_{1/2}$ = 2048 steps. The first gain update is over nearly an 84dB range while the latter update is over only a 6dB range. Yet, both updates take place over the same $N_1'$ and consequently the same $T_1'$ where $T_1' = N_1'Ts = 42.67$ms.

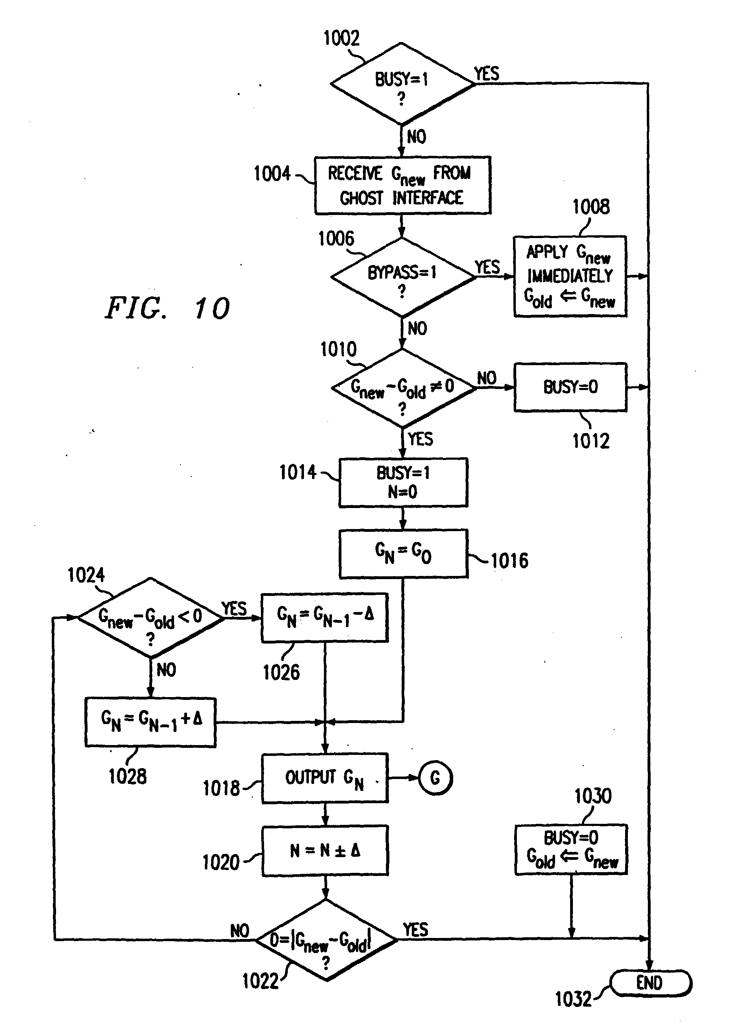

Figure 10 depicts in flowchart form the algorithm for controlling a linear constant-step gain update process. If the gain processor is busy (1002), it is currently processing a gain update and a new gain value will not be accepted. If the gain processor is not busy, a new value, $G_{new}$, is accepted by the $G_{host}$ interface (1004). Next, if the gain processor has been put into bypass mode (1006), $G_{new}$ is immediately applied (1008). If the gain processor is not in bypass mode, $G_{new}$ is compared to $G_{old}$ (1010), if the difference is 0, the busy flag is reset (1012) and the processor exits (1032). If the difference is not 0, the busy flag is set and step-counter n is set to 0 (1014). The new intermediate gain value $G_n$ is set to $G_0$ (1016) and is output as the current gain value G (1018). The value of n is incremented by D if $G_{new} - G_{old} > 0$ or decremented by D if $G_{new} - G_{old} < 0$ (1020). When the absolute value of $G_{new} - G_{old}$ = 0, the busy flag is reset and the value of $G_{old}$ is set to $G_{new}$ (1030) and the processor exits (1032). While the absolute value of $G_{new} - G_{old} \neq 0$, the intermediate gain value Gn is stepped either up or down. If $G_{new} - G_{old} < 0$ (1024) then $G_n$ is stepped down by a number of steps, D (1026). If $G_{new} - G_{old} > 0$ 1024 then $G_n$ is stepped up by a number of steps, D (1028). In either case, the new intermediate gain value $G_n$ is output as the current gain value G (1018). The value of n is then incremented by one (1020) and an exit or continuation of the gain update determination is made (1022).

Figure 11 illustrates a gain processor which implements the above algorithm. The host interface, $G_{Host}$, for the gain processor receives gain update signals from the host processor. In bypass mode, the new gain value $G_{new}$ is transferred through a multiplexor 1104 to a register 1106 holding the value $G_{new}$. It is then passed through a multiplexor 1108 to a register 1110 holding the value $G_{old}$. The value is then passed through a multiplexor 1118 to a register 1120. From register 1120, the $G_{new}$ value becomes the new gain output value 1124. In busy mode, the value of register 1106 is not updated and no gain update is made. In constant-step mode, register 1114, which holds the value $G_n$, is stepped in increments of D from $G_{old}$ to $G_{new}$ at adder 1116. The value of register $G_n$ is passed through a multiplexor 1118 to register 1120 after each step. From register 1120 the value becomes the new gain output value. A controller controls the bypass and busy signals of the gain processor. The controller 1124 also maintains a step counter, n and loads the registers 1106, 1110, and 1114.

In constant-time gain update, the number of update steps $N_1$ (and consequently, the update time $T_1$) is held constant, regardless of the specific choices of $G_{old}$ and $G_{new}$. In constant-time gain updating, the step size, D, changes for different pairs of $G_{old}$ and $G_{new}$ to enable $N_1$ to be maintained as a constant. Figures 12A and 12B depict the nature of $N_1$ in constant time updating. In Figure 12A, a gain update which sweeps from $G_{old} = 0$ to $G_{new} = $ maxgain takes $N_1$ steps. If $N_1 = 4096$, then the slope, D, 1202 of the gain sweep = 8. Likewise, in Figure 12B, a gain update which sweeps from $G_{old} = $ maxgain/2 to $G_{new} = $ maxgain also takes $N_1$ steps. However, in the latter example when $N_1 = 4096$, then the slope, D, 1202 of the gain sweep = 4.

Generally, a constant time, variable step size gain update would require significant hardware complexity as $\Delta$ is made dependent on the gain values $G_{old}$ and $G_{new}$. However, the disclosed method "filters" the "instantaneous" gain update function to yield a first-order gain update function with a constant-time gain update.

Figure 13 represents the linear constant-time filter output desired. The input gain change request from $G_{old}$ to $G_{new}$ merely specifies a step function. However, the disclosed gain processor will automatically translate this to a smoothed update, such as the linear response shown in Figure 13.

A comb filter, having an impulse response of $h(n) = 1/N_1$ where $0 \bullet n \bullet N_1 - 1$ and $h(n) = 0$ elsewhere, or having a z domain transfer function:

$$H(z) = \frac{1}{N_1} \bullet \frac{(1-z^{-N_1})}{1-z^{-1}}$$

will produce a desired response curve as shown in Figure 13. When factor $1/N_1$ is removed from the filter's transfer function, it yields the functions represented in time - domain difference equations as:

$$y(n) = x(n) - x(n - N_1) + y(n-1)$$

$$g(n) = \frac{y(n)}{N_1}$$

To implement these difference equations, the term $x(n - N_1)$, which, for $N_1 = 4096$ as an example, becomes $x(n - 4096)$, would require a storage of 4096 input signal values to be obtained. However, by observing the fact that input signal $x(n)$ takes on only two values, $G_{old}$ and $G_{new}$, and has a step-function profile as depicted in Figure 13, simple external control circuitry can be designed to generate the state variable $x(n - N_1)$.

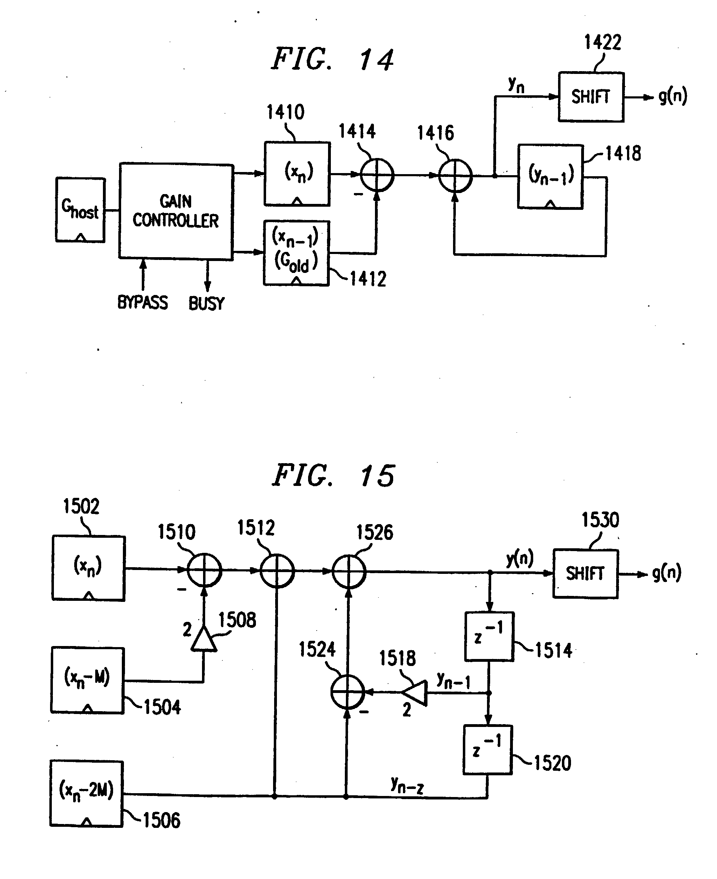

Figure 14 schematically depicts the implementation of the above difference equation. The initialization and values, when bypass = 0, during update of the registers $x_n$, $x_{n-N1}$, and $y_{n-1}$ are as follows:

| Counter | $x_n$ | $x_{n-N1}$ | $y_{n-1}$ | $g_n$ |
|---|---|---|---|---|
| $n = 0$ | $G_{old}$ | $G_{old}$ | $G_{old} {}^* N_1$ | $G_{old}$ |
| $0 < n \leq N_1 - 1$ | $G_{new}$ | $G_{old}$ | $y_{n-1}$ | $y_n/N_1$ |
| $n = N_1$ | $G_{new}$ | $G_{new}$ | $G_{new} {}^* N_1$ | $G_{new}$ |

The host interface, $G_{Host}$, receives a gain update command from its host. Gain controller maintains the busy and bypass indicators for the gain processor. The gain controller also maintains an internal counter to track the sweep update and to maintain the busy mode. The gain controller also loads values into registers 1410, 1412, and 1418, which hold the values for $x_n$, $x_{n-N1}$, and $y_{n-1}$, respectively. Registers 1410 and 1412 initially hold the value $G_{old}$. Once the counter maintained by gain controller increments past 0, the gain controller loads register 1410 with value $G_{new}$.

The value of register 1412 does not change during the gain update process. Adder 1414-subtracts the value of register 1412 from the value of register 1410. Adder 1416 adds the value of register 1418, which is initially loaded with value $G_{old}*N_1$, to the output of adder 1414. Also, once the counter maintained by gain controller increments past 0, the gain controller 1404 loads register 1418 with value $y_{n-1}$. When the counter is equal to the number of steps, $N_1$, register 1418 holds the value $G_{new}*N_1$. Value $y_n$ takes its value from the result of adder 1416. Shift 1422 is a right shifter which divides value $y_n$ by $N_1$ to produce the output $G_n$.

The counter maintained by the gain controller may take on values of 0 to $N_1$ - 1 only. The case of $n = N_1$ may be interpreted as the counter rolling over to 0 with Gold being replaced by $G_{new}$. The gain controller, during $0 < n \le N$ - 1 would be in the busy mode and therefore would not accept any new gain updates from the host.

For $N_1 = 4096$ and an output gain, g(n), of 16-bit gain, the addition operation, x(n) - x(n - 1), requires an adder 1414 of 17-bits as registers 1410 and 1412 would be 16 bits each. The feedback addition operation requires an adder 1416 of 30 bits as register 1418 is 30 bits in size.

The algorithm for linear, first-order, constant-time updates described above is extended to achieve a quadratic, second-order, update. In this case, a second-order filter response as depicted in Figure 1 is desired. The input gain change request from $G_{old}$ to $G_{new}$ merely specifies a step function. However, the disclosed gain processor will automatically generate a smoothed update, such as the quadratic response depicted in Figure 1. The response may be obtained using a second-order comb filter characterized by $M = N_2/2$, where M represents the midpoint of the number of steps in the update.

The polynomial fit is carried out on two time ranges: $0 \le n \le N$ and $N \le n \le 2N$. The midpoint of the curve, N, is defined by $(G_{new} + G_{old})/2$. For values on the curve $\le N$, $g(n) = \alpha_0 n^2 + \alpha_1$ where $g(0) = G_{old}$ and $g(N) = G_{new}$. Therefore, $\alpha_0 = (G_{new} - G_{old})/2$ and $\alpha_1 = G_{old}$. For values on the curve $\ge N$ and $\le 2N$, $g(n) = \beta_0(n - 2N)^2 + \beta_1$ where $g(N) = G_{new}$ - $G_{old}$ and $g(2N) = G_{new}$. Therefore, $\beta_0 = -(G_{new} - G_{old})/2$ or $-\beta_0$ and $\beta_1 = G_{new}$.

The time-domain transfer function of the comb filter which yields the response depicted in Figure 1 is:

$$y(n) = x(n) - 2x(n-M) + x(n-2M) + 2y(n-1) - y(n-2)$$

$$g(n) = \frac{y(n)}{M^2}$$

A sample implementation of the above time-domain transfer function as a comb filter is described in the following matlab code:

```
comb2.m


% implementation of the 2nd-order comb filter
```

```
% integrator is implemented as a second-order section
%
% Prashant P. Gandhi, August 1997
% Algorithm Implementation Code
%
% H(z) * M * M = [1 - 2 * z^(-M) + z^(-2 * M)]/[1 - 2 *z^(-1) +
z^(-2)]
% y(n) = x(n) - 2 * x(n-M) + x(n - 2 * M) + 2 * y(n - 1) - y(n
- 2)
%


clear all;
globdef;
regdef;


N = 11; M = 4; G0 = 0; G1 = 2^(gainbits - 1) - 1;
bb = [1 zeros(1,M - 1) - 2 zeros (1,M - 1) 1]; aa = [1 - 2 1];
x = [G1 G1*ones(1,N - 1)]

xy = filter(bb,1,x);
y = filter(1,aa,xy);
ym = y/(M * M);


xn = 0; xnM = 1; xn2M = 2;
yn1L = 3; yn1H = 4; yn2L = 5; yn2H = 6; yn = 7; x2tmp = 8;
yLtmp = 8;


for n = 1:N;
 if rem(n,25) =  = 0, fprintf('%d ',n); end;
 if n == 1
  yold1(n) = 0;       yold2(n) = 0;
 elseif n == 2
  yold1(n) = y2(n - 1);   yold2(n) = 0
 else
  yold1(n) - y2(n - 1);   yold2(n) - y2(n - 2);
 end
 if n< = M
  xoldM(n) = G0;          xold2M(n) = G0
```

```
elseif n> = M+1 & n< = 2 * M
 xoldM(n) = G1;         xold2M(n) = G0
else
 xoldM(n) = G1;         xold2M(n) = G1;
end;


x1(n) = x(n) -2 * xoldM(n);
x2(n) = x1(n) + xold2M(n);
y1(n) = x2(n) + 2 · * yold1(n);
y2(n) = y1(n) - yold2(n);
y3(n) - y2(n)/(M * M);


% Microcode DSP Instructions
%
 E = x(n);
i = 0;     nopalu([]);     st(e, xn);     xx(n) = E;
 E = xoldM(n);
i = 0;                     st(e,xnM);
 E = xold2M(n);
i = 0;                     st(e,xn2M);
i = 1;                     ld(xnM,bc);     xxnM(n) = B;
i = 2;     add(c,b,0,b);   ld(xn,a);       xxn(n) = A;
                           %B = 2 * x(n - M);
i = 3;     sub(a,b,0,b);   ld(xn2M,a);     xxn2M(n) = A;
                    xx1(n) = B;     %B = x1(n)
i = 4; ·   add(a,b,0,a);        ld(yn1L,bc);   xx2(n) = A;
                    yold1L(n) = B; %A  =  x2(n),   xx2(n)   is
unsigned
i = 5;                     st(a,x2tmp);               %save x2
i = 6;     addg0(c,b,0,a); ld(yn1H,bc);   yoldH(n) = B;
                    zyold1L(n) = A;     carry1(n) = c2out_reg;
                           %A  =  2  *  yn1L,  gen
carry1
i = 7;     addg1(c,b,0,c); ld(x2tmp,b);   zyoldH(n) = C;
                           %C = 2 * yn1H + carry1
i = 9;     addg0(a,b,0,a); y1L(n) = A; carry2(n) = c20out_reg;
                           %A  =  2  *  yn1L  +  x2,  gen
carry2
```

```
i = 10      addg1(c,bmsb,0,c);   ld(yn2L,b);     y1H(n) = C;
                 yold2L(n) = B; %C = 2 * yn1H + carry1 + carry2
i = 11;     subg0(a,b,0,a);ld(yn2H,b);     yL(n) = A;
                 yold2H(n) = B; carry3(n) = c2out_reg;
                                %A = y1L - yn2L, gen carry3
i = 12;     subg1(c,b,0,c);st(a,yLtmp);    yH(n) = C;
                                %C = y1H - yn2H + carry3
i = 13;                    ld(yn1L,a);
i = 14;                    st(a,yn2L);
i = 15;                    ld(yn1H,a);
i = 16;                    st(a,yn2H);
i = 17;                    ld(yLtmp,a);
i = 18;                    st(a,yn1L);
i = 19;                    st(c,yn1H);


end;
%
% Check  for  error  between  algorithm  implementation  and
microcode
%
err = sum(abs(yL + yH * M * M - y2));
if err~ = 0
 fprintf('\n ERROR in Gain Computation\n')
else
 fprintf('\n Gain Computation is OK\n')
end;
```

For M = 1024, x(n - M) and x(n - 2M) would require storage of 2048 input signal values. However, the algorithm shown in the table below allows an external controller that generates state variables to eliminate the 4 kilobyte word storage requirement for a 16-bit gain value.

| Cond. and Count | $x_n$ | $x_{n-M}$ | $x_{n-2M}$ | $y_{n-1}$ | $y_{n-2}$ | $g_n$ |
|---|---|---|---|---|---|---|
| $G_{old} = G_{new} n = 0$ | $G_{old}$ | $G_{old}$ | $G_{old}$ | $G_{old}*M^2$ | $G_{old}*M^2$ | $G_{old}$ |
| $G_{old} = G_{new} n = 0$ | $G_{new}$ | $G_{old}$ | $G_{old}$ | $G_{old}*M^2$ | $G_{old}*M^2$ | $G_{new}/M^2$ |
| $1 \leq n \leq M - 1$ | $G_{new}$ | $G_{old}$ | $G_{old}$ | $y_{n-1}$ | $y_{n-2}$ | $y_n/M^2$ |
| $M \leq n \leq 2M - 1$ | $G_{new}$ | $G_{new}$ | $G_{old}$ | $y_{n-1}$ | $y_{n-2}$ | $y_n/M^2$ |
| $n \geq 2M$ | $G_{new}$ | $G_{new}$ | $G_{new}$ | $G_{new}M^2$ | $G_{new}M^2$ | $G_{new}$ |

For $n \geq 2M$, the counter is reset to 0 with $G_{old} = G_{new}$, and $G_{new} = G_{host}$.

Figure 15 depicts a sample of a gain processor which implements the above algorithm table, where M = 1024 or $N_2$ = 2048. Register 1502, which holds the value $x_n$, is initially loaded with value $G_{new}$. Registers 1504 and 1506, which hold the values $x_{n-M}$ and $x_{n-2M}$, respectively, are initially loaded with the value $G_{old}$. The value of $y_{n-1}$ and $y_{n-2}$ at

the first step, n = 0, is $G_{old} * M^2$. The output, g(n) is $G_{old}$. Then, while the counter, n, is less than or equal to 1/2 of the steps in the gain sweep, 2M, registers 1502, 1504, and 1506 remain unchanged. Multiplier 1508 multiplies the value of register 1504 by two. Adder 1510 subtracts the product of multiplier 1508 from the value of register 1502. Adder 1512 adds the result of adder 1510 to the value of register 1506. The value of $y_{n-1}$ is dictated by the feedback loop of y(n) and unit delay 1514. The value of $y_{n-1}$ is multiplied by two at multiplier 1518. The value of $y_{n-2}$ is generated by the unit delay 1520 in the feedback loop of y(n). Adder 1524 subtracts the value of $y_{n-2}$ from the product of multiplier 1518. Adder 1526 adds the result of adder 1512 to the result of adder 1524. The result of adder 1526 is y(n). This result is input into Shift 1530 a right shifter which divides the value $y_n$ by $M^2$ to produce the output gain signal, g(n). The counter, n, is incremented after each series of operations. While the counter, n, is greater than or equal -to 1/2 of the steps in the gain sweep, 2M, register 1504 is set to $G_{new}$. The above steps remain unchanged. Once the counter, n, reaches 2M, registers 1502, 1504, and 1606 and g(n) are valued at $G_{new}$.

A controller for the gain processor depicted in Figure 15 preferably implements the following features: apply a gain of 0 (mute) on power up; maintain a busy state during gain updates to prevent gain from being altered; while in a steady-state, the applied gain would be forced to equal $G_{old}$ allowing for recovery from "rare" gain errors which could be caused by noise on a line, faulty power supplies, or errors in the physical device; maintain a bypass state such that $G_{old} = G_{new} = G_{host}$ with the applied gain being $G_{old}$.

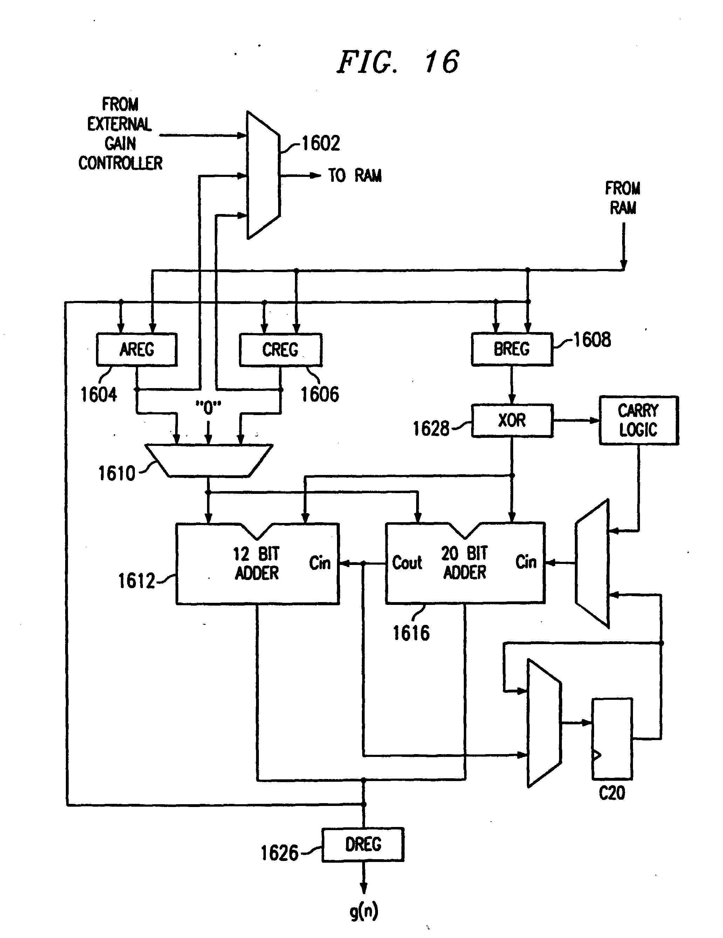

Figure 16 depicts a microcode cycle-based DSP implementation of the table algorithm with a single adder. The filter may be efficiently implemented, for an example, with g(n) represented in 20 bits and M = 1024, that is, $N_2 = 2048$ or $T_2 = 46.44$ms at fs = 44.1kHz. The RAM words of the DSP are assigned, in this embodiment, as follows:

$G_{old}$, $G_{new} = x_n$, $x_{n-M}$ and $x_{n-2M}$: lower 20 of the 32-bits with gain values and upper 12 bits set to 0.

The values $y_n$, $y_{n-1}$, and $y_{n-2}$ are assigned two RAM words each: least significant word, LSW, and most significant word, MSW. The lower 20 bits of the MSW of $y_n$, $y_{n-1}$ and $y_{n-2}$ are set to $G_{old}$ while the remaining upper 12 bits as well as all 32 bits of the LSW of $y_n$, $y_{n-1}$ and $y_{n-2}$ are set to 0, during initialization.

The MSW of $y_n = g_n$ with the lower 20 bits being the valid $g_n$.

A multiplexor 1602, controlled by a gain controller, is used as a data selector to provide input to the RAM words described above. Registers 1604, 1606, and 1608 are 32 bit registers which are loaded with values, $x_n$, $x_{n-M}$, $x_{n-2M}$, $y_n$, $y_{n-1}$, and $y_{n-2}$ from RAM as needed to perform the appropriate step of the filter. A multiplexor 1610 is used as a data selector, determining which value to load into the adder 1612 and 1616. The two feed-forward additions (x(n) + (-2x(n - M)) + x(n - 2M) are carried out as normal additions. Each feedback addition 1524 and 1526, on the other hand, is carried out in two clock cycles: one cycle to add LSWs and another cycle to add the MSWs. Special addition/subtraction instructions are used for LSW and MSW operations. When the LSW add is performed, the Cout of the 20-bit adder 1616 is stored into flip-flop C20. The value of flip-flop C20 is used as the Cin to the 20-bit adder 1616 during the MSW addition operation. The value, $2+y_{n-1}$ is implemented by adding two LSWs of $y_{n-1}$, storing the Cout of adder 1616 in C20, passing it as the Cin of the 12-bit adder 1612 at the next clock and adding the two MSWs of $y_{n-1}$. Shifter 1628 carries out the multiply by two operations of multipliers 1508 and 1518 and the shift function of 130. A register 1626 holds the value g(n) for output.

In the presently preferred embodiment, this DSP is implemented with a datapath size which is less than 40 bits. This 32 bit implementation allows for a 25-33% processor area reduction. However, twice as many addition operations and twice as many RAM storage words are required for feedback processing. If DSP area cost is not a concern, the above implementation may be altered to accommodate a 40-bit or larger datapath.

Figure 2 depicts a block diagram of the signal processing path of a sample audio system which advantageously utilizes the soft gain update. An equalizer, audio tone control, and volume control are each part of a digital signal processing hardware which also includes a DSP control processor, control circuitry 218 and memory. The equalizer receives digital audio data. The data is processed by the DSP hardware. Digital to analog circuitry converts the signal for output as analog audio. When a gain update command is received by the DSP control processor from user input, the DSP control processor commands the volume control block, via the DSP control circuitry, to update the gain accordingly. The volume control block utilizes the soft gain update.

In a sample implementation of linear constant-time soft gain updates, the best mode presently contemplated for sweep time is in the neighborhood of 90ms. In a sample implementation of quadratic constant-time soft gain updates, the best mode presently contemplated for sweep time is in the neighborhood of 45ms. Linear sweep times of between 70ms and 110ms and quadratic sweep times of between 35ms and 55ms are preferred because they provide the listener a pleasant gain update response. Linear sweep times of less than 70ms or more than 110ms and quadratic sweep times of less than 35ms or more than 55ms are less preferred due to a greater amount of audible artifacts occurring when such sweep times are used.

As will be recognized by those skilled in the art, the innovative concepts described in the present application can be modified and varied over a tremendous range of applications, and accordingly the scope of patented subject matter is not limited by any of the specific exemplary teachings given.

In the preferred embodiment, a 16-bit audio application is contemplated. However, audio applications of varying bit resolutions can take advantage of the present disclosure.

The number of steps between mute and maxgain in the preferred embodiment is 4096. (32768 levels with a slope, D, of 8). However, the slope can be varied, by either powers of two or some other number, to produce a steeper or flatter response.

Like the slope, the sample rate, fs, can differ among audio applications. As the sample rate changes, the sweep time for constant-step soft gain update will vary accordingly.

The soft gain update described above is not limited only to first and second order functions. It can be used with higher ordered functions as well, each function having a greater continuity at $G_{new}$ and $G_{old}$. Therefore, each higher ordered functions will produce fewer audible artifacts at gain update. However, implementation of such higher ordered function will demand a greater amount of DSP resources. Preferable sweep times for higher ordered function are in the neighborhood of one-half of the preferred sweep time for the function of the next lowest order. That is, a preferred third order soft gain update sweep time will be in the neighborhood of 22.5ms (1/2 of 45ms, the preferred sweep time for a quadratic update).

It should also be noted that the three main embodiments above are not exhaustive, and other algorithms can be used for smooth automatic updating.

## Claims

1. An audio amplification system, comprising:

   audio amplifier circuitry; and
   a controller for controlling the gain of said amplifier circuitry, and for changing the gain of said amplifier circuitry according to a predetermined romping function in response to a gain-change command.

2. The system as claimed in Claim 1, wherein the said controller is arranged for changing the gain of the amplifier circuitry in a plurality of steps.

3. The system as claimed in Claim 2, wherein at least one of said plurality steps occurs after the end of said gain-change command.

4. The system as claimed in any preceding claim, wherein the controller is arranged for changing the gain of the amplifier smoothly.

5. The system of Claim 4, wherein the controller is arranged for changing the gain of the amplifier over a predetermined and extended period.

6. The system as claimed in any preceding claim, wherein the controller is arranged for changing the gain of the amplifier according to a predetermined smoothing function of at least the second order.

7. The system as claimed in any preceding claim, wherein said controller is integrated with said amplifier circuitry.

8. The system as claimed in any preceding claim, wherein said controller comprises car-radio control functions.

9. The system as claimed in any preceding claim, wherein said controller comprises a DSP core that is integrated with custom peripherals for I/O functions.

10. The system as claimed in any preceding claim, wherein said controller is arranged for changing the gain in less than 110 milliseconds.

11. The system as claimed in any preceding claim, wherein said controller is arranged for changing the gain in less than 55 milliseconds.

12. The system as claimed in any preceding claim, wherein said controller is arranged such that it does not respond to successive gain-change commands while it is changing the gain of said amplifier circuitry.

13. The system as claimed in any preceding claim, wherein said controller is arranged for changing the gain of said amplifier circuitry automatically.

**14.** A method of gain update of a signal comprising:

receiving a gain-change command;
automatically changing the gain of said signal in a plurality of steps according to a predetermined ramping function.

**15.** The method as claimed in Claim 14 further comprising:
performing the step of changing the gain in less than 110 milliseconds.

**16.** The method as claimed in Claim 14 or 15 further comprising:
preventing performance of said step of receiving the gain change command while the step of automatically changing the gain is performed.

## FIG. 1

$$midpoint = \frac{G_{new} - G_{old}}{2} + G_{old}$$

$$= \frac{G_{new} + G_{old}}{2}$$

## FIG. 2

## FIG. 3

## FIG. 4

FIG. 5
(PRIOR ART)

FIG. 6

FIG. 7

FIG. 8

FIG. 9

*FIG. 10*

1002 — $\text{BUSY}=1$ ? — YES

NO

1004 — RECEIVE $G_{new}$ FROM GHOST INTERFACE

1006 — $\text{BYPASS}=1$ ? — YES

1008 — APPLY $G_{new}$ IMMEDIATELY $G_{old} \Leftarrow G_{new}$

NO

1010 — $G_{new}-G_{old} \neq 0$ ? — NO — 1012 — $\text{BUSY}=0$

YES

1014 — $\text{BUSY}=1$ $N=0$

1016 — $G_N = G_O$

1024 — $G_{new}-G_{old} < 0$ ? — YES — 1026 — $G_N = G_{N-1}-\Delta$

NO

1028 — $G_N = G_{N-1}+\Delta$

1018 — OUTPUT $G_N$ — (G)

1020 — $N = N \pm \Delta$

1022 — $D=|G_{new}-G_{old}|$ ? — NO / YES

1030 — $\text{BUSY}=0$ $G_{old} \Leftarrow G_{new}$

1032 — END

15

*FIG. 11*

*FIG. 12A*

*FIG. 13*

*FIG. 12B*

## FIG. 14

## FIG. 15

## FIG. 16